**Europäisches Patentamt**

**European Patent Office**

**Office européen des brevets**

(19)

(11) Veröffentlichungsnummer : **0 477 403 B1**

(12)

# EUROPÄISCHE PATENTSCHRIFT

(45) Veröffentlichungstag der Patentschrift :
**18.01.95 Patentblatt 95/03**

(51) Int. Cl.$^6$ : **H04Q 3/52**

(21) Anmeldenummer : **90118489.5**

(22) Anmeldetag : **26.09.90**

(54) **Breitbandsignal-Koppeleinrichtung mit Ladungstransferschaltung in den Ausgangsleitungen.**

(43) Veröffentlichungstag der Anmeldung :
**01.04.92 Patentblatt 92/14**

(45) Bekanntmachung des Hinweises auf die
Patenterteilung :
**18.01.95 Patentblatt 95/03**

(84) Benannte Vertragsstaaten :
**AT BE CH DE FR GB IT LI NL SE**

(56) Entgegenhaltungen :
**EP-A- 0 262 479**
**EP-A- 0 354 254**

(73) Patentinhaber : **SIEMENS
AKTIENGESELLSCHAFT
Wittelsbacherplatz 2
D-80333 München (DE)**

(72) Erfinder : **Heiduk, Gerhard, Dipl.-Phys.
Stiftsbogen 39
W-8000 München 70 (DE)**

## Beschreibung

Läßt sich die ECL-Technik durch Eigenschaften wie hohe Arbeitsgeschwindigkeit, (mittel-)hoher Integrationsgrad und (mittel-) hohe Verlustleistung charakterisieren, so zeichnet sich die FET-Technik - bei demgegenüber allerdings nur mittleren Arbeitsgeschwindigkeiten - durch einen sehr hohen Integrationsgrad und sehr niedrige Verlustleistungen aus. Diese letzteren Eigenschaften führen zu dem Bemühen, mit integrierten Schaltungen in FET-Technik auch in bislang der Bipolar-Technik vorbehaltene Geschwindigkeitsbereiche vorzudringen.

So weist eine (z.B. aus EP-A-0 262 479) bekannte Breitbandsignal-Koppeleinrichtung eine Koppelpunktmatrix in FET-Technik auf,
deren Koppelelemente jeweils mit einem an seiner Steuerelektrode mit einem Durchschalte- bzw. Sperrsignal beaufschlagten, mit einer Hauptelektrode an die zugehörige Matrixausgangsleitung angeschlossenen Schalter-Transistor gebildet sind,
wobei die Koppelelemente jeweils einen mit dem Schalter-Transistor eine Serienschaltung bildenden Vorschalt-Transistor aufweisen,
der mit seiner Steuerelektrode an die zugehörige Matrixeingangsleitung angeschlossen ist und dessen der Serienschaltung abgewandte Hauptelektrode über einen Abtast-Transistor mit dem einen Anschluß der Betriebsspannungsquelle verbunden ist, mit deren anderen Anschluß die jeweilige Matrixausgangsleitung über einen Vorlade-Transistor verbunden ist,
und wobei Vorlade-Transistor und Abtast-Transistor gegensinnig zueinander jeweils an ihrer Steuerelektrode mit einem eine Bit-Durchschaltezeitspanne in eine Vorladephase und die eigentliche Durchschaltephase unterteilenden Koppelfeld-Ansteuer-Takt beaufschlagt sind, so daß in jeder Vorphase bei gesperrtem Abtast-Transistor die Matrixausgangsleitung über den Vorlade-Transistor zumindest angenähert auf das an dem genannten anderen Anschluss der Betriebsspannungsquelle herrschende Potential geladen wird. Diese bekannte Breitbandsignal-Koppeleinrichtung, die koppelelement-individuelle Abtasttransistoren oder matrixeingangsleitungs- oder matrixausgangsleitungs-individuelle Abtast-Transistoren aufweisen kann, benötigt zur Ansteuerung dieser Abtast-Transistoren eigene, die Koppelpunktmatrix durchziehende Taktleitungen, was einen entsprechenden Flächenbedarf erfordert und eine entsprechende kapazitive Belastung der Matrixausgangsleitungen mit sich bringt; Taktverteilung und Kopplungen zwischen Matrixeingangsleitungen und Matrixausgangsleitungen erfordern zur Gewährleistung einer ausreichenden Störsicherheit ausreichend große Signalamplituden auf den Matrixausgangsleitungen, was mit einem relativ hohen Leistungsverbrauch verbunden ist.

Eine (z.B. aus EP-A-0 354 252) bekannte andere Breitbandsignal-Koppeleinrichtung weist eine Koppelpunktmatrix in FET-Technik auf,
deren Eingänge jeweils mit einer Eingangstreiberschaltung versehen sein können,
deren Ausgänge jeweils mit einer Ausgangsverstärkerschaltung versehen sind und
deren jeweils von einer Halte-Speicherzelle gesteuerten Koppelelemente jeweils mit einer **Serienschaltung** eines an seiner Steuerelektrode mit einem Durchschalte- bzw. Sperrsignal beaufschlagten Schalter-Transistors und eines mit seiner Steuerelektrode an die zugehörige Matrixeingangsleitung angeschlossenen Eingangs-Transistors gebildet sind, **die** mit der der Serienschaltung abgewandten Hauptelektrode des einen Transistors an die zugehörige Matrixausgangsleitung angeschlossen ist, wobei die Matrixausgangsleitung über einen Transistor mit dem einen Anschluß der Betriebsspannungsquelle verbunden ist;
dabei ist es so, daß die der Serienschaltung abgewandte Hauptelektrode des anderen Transistors kontinuierlich mit dem anderen Anschluß der Betriebsspannungsquelle verbunden ist und daß die Transistor-Serienschaltung jedes Koppelelements den koppelpunktindividuellen einen Zweig eines Differenzverstärkers bildet, dessen jeweils den zu ein und derselben Ausgangsleitung führenden Koppelpunkten gemeinsamer anderer Zweig durch die eine **Serienschaltung** eines mit seiner Steuerelektrode an dem anderen Anschluß der Betriebsspannungsquelle liegenden ersten Transistors und eines an seiner Steuerelektrode mit einer Referenzspannung beaufschlagten zweiten Transistors aufweisende matrixausgangsleitungs-individuelle Ausgangsverstärkerschaltung gebildet ist, **die** mit der der Serienschaltung abgewandten Hauptelektrode des einen Transistors an die zugehörige Matrixausgangs-leitung angeschlossen ist und **deren** der Serienschaltung abgewandte, zum Verstärkerausgang führenden Hauptelektrode des anderen Transistors über einen Lasttransistor mit dem genannten anderen Anschluß der Betriebsspannungsquelle verbunden ist.

Dieses Konzept eines "verteilten" Differenzverstärkers erfordert zum einen eine relativ hohe Genauigkeit der genannten Referenzspannung und damit einen entsprechend aufwendigen Referenzspannungsgenerator; zum anderen ist für den verteilten Differenzverstärker auch das sog. Transistor-Matching problematisch, d.h. die Bereitstellung von in ihren Kennwerten einander entsprechenden Transistoren.

Die Erfindung stellt sich nun die Aufgabe, einen Weg zu einer Breitbandsignal-Koppelanordnung zu zeigen, die solche Probleme vermeidet.

Die Erfindung betrifft eine Breitbandsignal-Koppeleinrichtung mit einer Koppelpunkt-Matrix in FET-Technik,

deren Eingänge jeweils mit einer Eingangstreiberschaltung versehen sein können,

deren Ausgänge jeweils mit einer Ausgangsverstärkerschaltung versehen sind und

deren jeweils von einer Halte-Speicherzelle (Hij) gesteuerten Koppelelemente jeweils mit einer **Serienschaltung** eines an seiner Steuerelektrode mit einem Durchschalte- bzw. Sperrsignal beaufschlagten Schalter-Transistors und eines mit seiner Steuerelektrode an die zugehörige Matrixeingangsleitung angeschlossenen Eingangs-Transistors gebildet sind, **die** mit der der Serienschaltung abgewandten Hauptelektrode des einen Transistors an die zugehörige Matrixausgangsleitung angeschlossen ist, welche ihrerseits über einen Vorladetransistor, der mit seinem Steuereingang an die Taktsignalleitung eines eine Bit-Durchschaltezeitspanne in eine Vorladephase und eine Bewertungsphase unterteilenden Koppelfeldansteuertaktes angeschlossen ist, mit einer Vorladepotentialquelle verbunden ist, wobei in jeder Vorladephase der Eingangstransistor gesperrt und die Matrixausgangsleitung vorgeladen wird; diese Breitbandsignal-Koppelanordnung ist erfindungsgemäß dadurch gekennzeichnet, daß jeweils zwischen die Matrixausgangsleitung und die Ausgangsverstärkerschaltung ein zusammen mit dem am Eingang der Ausgangsverstärkerschaltung liegenden Vorladetransistor eine Ladungstransferschaltung bildender, mit seiner Steuerelektrode an einer Referenzpotentialquelle liegender n-Kanal-Längstransistor eingefügt ist.

Es sei an dieser Stelle bemerkt, daß eine Ladungstransferschaltung mit einem zwischen zwei kapazitiven Lasten liegenden, an seiner Steuerelektrode mit einer Referenzspannung beaufschlagten n-Kanal-Längstransistor und einem taktgesteuerten Vorladetransistor an sich (aus Annaratone: "Digital CMOS Circuit Design" Kluwer Academic Publishers 1986, p. 198...200) bekannt ist; nähere Berührungspunkte mit der der Erfindung zugrundeliegenden Problematik und deren Lösung sind indessen nicht gegeben.

Die Erfindung bringt neben dem mit einer Ladungstransferschaltung der angegebenen Art verbundenen Vorteil einer Spannungsverstärkung den weiteren Vorteil mit sich, daß eine genaue Einstellung der Referenzspannung nicht erforderlich ist und daher auch keine genaue und empfindliche Referenzspannungsquelle benötigt wird; die Referenzspannung lässt sich vielmehr leicht durch interne Spannungsteilung aus der Betriebsspannung ableiten, wobei es zweckmässig ist, daß in weiterer Ausgestaltung der Erfindung die Referenzspannungsleitung durch einen Kondensator gut gegenüber dem Bezugspotential (Masse) abgeblockt ist. Auch ein Transistor-Matching spielt keine Rolle; technologiebedingte Kennwertschwankungen verändern lediglich den Signalhub auf der Ausgangsleitung, auf der indessen bereits ein kleiner Hub von z.B. 0,5 V genügt, um ein sicheres Erkennen des jeweils durchgeschalteten Bits am Ausgangsverstärker zu gewährleisten, wobei aus einem kleinen Signalhub auch eine entsprechend geringe Verlustleistung resultiert. Die Breitbandsignal-Koppelanordnung gemäß der Erfindung lässt sich auch mit reduziertem Signalhub auf der Eingangsleitung betreiben.

Die Sperrung des Eingangstransistors in jeder Vorladephase kann, wenn man keinen (aus EP-A-0 262 479 bekannten) Abtast-Transistor in der Betriebsspannungszuführung des Koppelelements vorsehen will, beispielsweise mit Hilfe von in die Eingangsleitungen eingefügten, jeweils mit ihrem Steuereingang an die Taktsignalleitung angeschlossenen und gegensinnig zu den Vorlade-Transistoren gesteuerten Gatterschaltungen bewirkt werden, wie dies im Prinzip ebenfalls bereits (aus EP-A-0 451 312) bekannt ist.

In weiterer Ausgestaltung der Erfindung kann aber auch ein Vorladetransistor, der am Eingang einer einer Matrixeingangsleitung vorgeschalteten Eingangstreiberschaltung vorgesehen ist, mit seiner Steuerelektrode an die Vorlade-Bewertungs-Taktsignalleitung angeschlossen sein, von der her zugleich auch ein der Eingangstreiberschaltung vorgeschaltetes Transfer-Gate gesteuert wird.

Weitere Besonderheiten der Erfindung werden aus der nachfolgenden näheren Erläuterung der Erfindung anhand der Zeichnungen ersichtlich. Dabei zeigen

FIG 1      das Schema einer Breitband-Koppeleinrichtung und

FIG 2      Einzelheiten ihrer schaltungstechnischen Realisierung gemäß der Erfindung;

FIG 3      verdeutlicht den Koppelfelddurchschaltetakt darin.

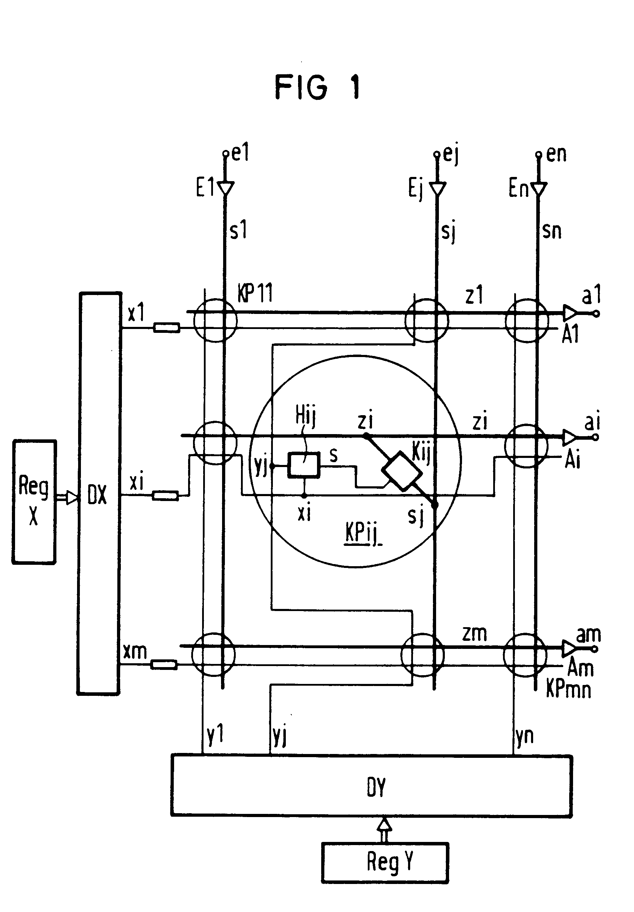

In der Zeichnung FIG 1 ist schematisch in zum Verständnis der Erfindung erforderlichem Umfange eine Breitbandsignal-Koppeleinrichtung skizziert, an deren zu Spaltenleitungen s1...sj...sn einer Koppelpunktmatrix führenden Eingängen e1...ej...en Eingangstreiberschaltungen E1...Ej...En vorgesehen sind und deren von Zeilenleitungen z1...zi...zm der Koppelpunktmatrix erreichte Ausgänge a1...ai...am mit Ausgangsverstärkerschaltungen A1...Ai...Am versehen sind.

Die Koppelpunktmatrix weist Koppelpunkte KP11...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert sein können, deren Ausgang s zum Steuereingang des jeweiligen Koppelelements (Kij beim Koppelpunkt KPij) führt.

Die Halte-Speicherzellen ...Hij... werden gemäß FIG 1 durch zwei Ansteuerdecoder, nämlich einen Zeilen-

3

decoder DX und einen Spaltendecoder DY, über entsprechende Ansteuerleitungen x1...xi...xm; y1...yj...yn in zwei Koordinaten angesteuert.

Dazu mögen, wie dies aus FIG 1 ersichtlich ist, die beiden Ansteuerdecoder DX, DY von Eingangsregistern Reg X, Reg Y her jeweils mit einer einer Matrixreihe (Zeile bzw.Spalte) von Koppelpunkten gemeinsamen Koppelpunktzeilen- bzw. Koppelpunktspalten-Adresse beaufschlagbar sein, auf die hin sie jeweils an der der jeweiligen Koppelpunktreihen-Adresse entsprechenden Ansteuerleitung jeweils ein "1"-Ansteuersignal abgeben. Das Zusammentreffen eines Zeilenansteuersignals "1" und eines Spaltenansteuersignals "1" am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, wird wiederum der Ansteuerdecoder DX vom Eingangsregister Reg X mit der betreffenden Zeilenadresse beaufschlagt, so daß der Zeilendecoder DX wiederum auf seiner Ausgangsleitung xi ein Zeilenansteuersignal "1" abgibt, und zugleich wird der Spaltendecoder DY von seinem Eingangsregister Reg Y her beispielsweise mit einer Leeradresse oder mit der Adresse einer Spalte von unbeschalteten Koppelpunkten beaufschlagt, so daß er auf seiner Ausgangsleitung yj ein Spaltenansteuersignal "0" abgibt; das Zusammentreffen von Zeilenansteuersignal "1" und Spaltenansteuersignal "0" bewirkt dann die Rücksetzung der Halte-Speicherzelle Hij mit der Folge, daß das von ihr gesteuerte Koppelelement Kij gesperrt wird.

Die Halte-Speicherzellen ...Hij... können in an sich bekannter Weise ausgebildet sein, beispielsweise so, wie dies aus der EP-A-0 238 834 ersichtlich ist und hier daher nicht weiter erläutert zu werden braucht.

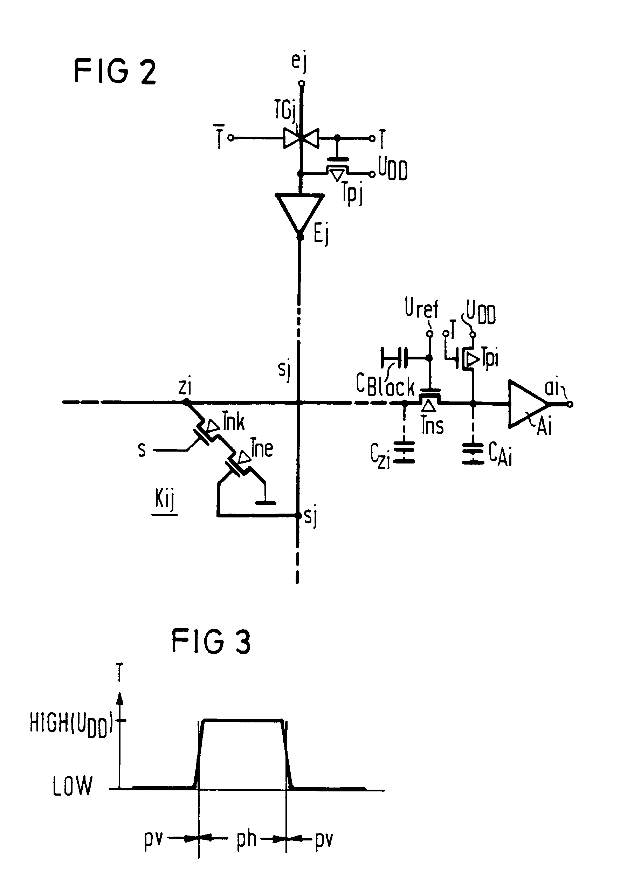

Wie die Koppelelemente ...Kij... schaltungstechnisch realisiert sein können, wird in FIG 2 verdeutlicht: Die Koppelelemente ...Kij... sind jeweils mit einer **Serienschaltung** eines an seiner Steuerelektrode von der Halte-Speicherzelle her mit einem Durchschalte- bzw. Sperrsignal beaufschlagten Schalter-Transistors Tnk und eines mit seiner Steuerelektrode an die zugehörige Matrixeingangsleitung sj angeschlossenen Eingangs-Transistors Tne gebildet, **die** mit der der Serienschaltung abgewandten Hauptelektrode des einen Transistors Tnk an die zugehörige Matrixausgangsleitung zi angeschlossen ist; die Matrixausgangsleitung zi ihrerseits ist über einen n-Kanal-Längstransistor Tns mit dem Eingang der Ausgangsverstärkerschaltung Ai verbunden, wobei am Eingang der Ausgangsverstärkerschaltung Ai außerdem ein Vorladetransistor Tpi liegt,über den (in Serie mit dem Längstransistor Tns) die zugehörige Matrixausgangsleitung zi in jeder Vorladephase pv (in FIG 3) einer durch einen Koppelfeldansteuertakt T (in FIG 3) in eine solche Vorladephase pv (in FIG 3) und eine Bewertungsphase ph (in FIG 3) unterteilten Bit-Durchschaltezeitspanne mit einer Vorladepotentialquelle $U_{DD}$ verbunden ist. Der Vorladetransistor Tpi liegt dazu mit seinem Steuereingang an der Taktsignalleitung T (in FIG 2) des Koppelfeldansteuertaktes.

Der zwischen die Matrixausgangsleitung zi und die Ausgangsverstärkerschaltung Ai eingefügte n-Kanal-Längstransistor Tns liegt mit seiner Steuerelektrode an einer Referenzpotentialquelle $U_{ref}$, wobei für das Referenzpotential ($U_{ref}$) und das zuvor erwähnte Vorladepotential ($U_{DD}$) die Beziehung $U_{ref}$ $U_{DD}$ gilt. Durch einen Kondensator $C_{Block}$ ist die Referenzpotentialquelle $U_{ref}$ gegen Masse gut abgeblockt.

Der zwischen der Matrixausgangsleitung zi und der Ausgangsverstärkerschaltung Ai liegende n-Kanal-Längstransistor Tns bildet zusammen mit dem am Eingang der Ausgangsverstärkerschaltung Ai liegenden Vorladetransistor Tpi eine Ladungstransferschaltung, auf die bei der nachfolgenden weiteren Erläuterung der Wirkungsweise der in FIG 2 skizzierten Schaltungsanordnung noch zurückgekommen wird; zuvor sei jedoch noch die schaltungstechnische Ausgestaltung an dem zur Spaltenleitung sj der Koppelpunktmatrix führenden Eingang ej der Breitbandsignal-Koppeleinrichtung betrachtet:

Gemäß FIG 2 ist der Matrixeingangsleitung (Spaltenleitung) sj eine Eingangstreiberschaltung Ej vorgeschaltet, der ihrerseits ein mit seinen beiden Steuereingängen an der den Koppelfeldansteuertakt führenden Taktsignalleitung T bzw. an einer den negierten Koppelfeldansteuertakt führenden Taktsignalleitung $\overline{T}$ liegendes Transfer-Gate TGj vorgeschaltet ist. Am Eingang der Eingangstreiberschaltung Ej liegt ein weiterer Vorladetransistor Tpj, der mit seiner Steuerelektrode ebenfalls an die Vorladephase-Bewertungsphase-Taktsignalleitung T angeschlossen ist.

Die in FIG 2 skizzierte Schaltungsanordnung arbeitet dann wie folgt:

Während der Vorladephase (pv in FIG 3) ist der eingangsseitige Vorladetransistor Tpj leitend, so daß der Eingang der Eingangstreiberschaltung Ej ein Steuerpotential annimmt, aufgrund dessen der Ausgang der Eingangstreiberschaltung Ej und damit die Spaltenleitung sj auf das Bezugspotential (OV, Masse) gelangt mit der Folge, daß der Eingangstransistor Tne - und damit auch die Serienschaltung von Eingangstransistor Tne und Schaltertransistor Tnk - in den Sperrzustand gelangt.

Der Eingang des Ausgangsverstärkers Ai wird in der Vorladephase (pv in FIG 3) über den Vorladetransistor Tpi auf das $U_{DD}$-Potential gezogen, was zur Folge hat, daß über den n-Kanal-Längstransistor Tns die Matrixausgangsleitung (Zeilenleitung) zi auf ein Potential $U_{ref}$-$U_{th}$ gelangt, worin $U_{th}$ die Schwellenspannung des Längstransistors Tns ist.

Mit dem Übergang des Koppelfeldansteuertaktsignals T (in FIG 3) von LOW auf HIGH ($U_{DD}$) endet die Vorladephase (pv in FIG 3) und beginnt die nachfolgenden Bewertungsphase (ph in FIG 3). Der Vorladetransistor Tpj am Eingang der Eingangstreiberschaltung Ej wird gesperrt, und das Transmission-Gate TGj wird leitend mit der Folge, daß je nachdem am Eingang Ej gerade anstehenden durchzuschaltenden Bit die Matrixeingangsleitung (Spaltenleitung) sj auf ihrem bisherigen Potential (OV, Masse) verbleibt oder aufgeladen wird.

Im ersten Fall bleibt das Potential der Matrixausgangsleitung (Zeilenleitung) zi unverändert, während im zweiten Fall die Matrixausgangsleitung zi über die Serienschaltung von Eingangs-Transistor Tne und Schalter-Transistor Tnk des gerade betrachteten, im Durchschaltezustand befindlichen Koppelelements Kij entladen wird. Durch diese Potentialänderung auf der Matrixausgangsleitung zi wird der n-Kanal-Längstransistor Tns, der zuvor in der Vorladephase bei Unterschreiten seiner Schwellenspannung in den Sperrzustand gelangt war, aufgrund des nunmehrigen Überschreitens seiner Schwellenspannung wieder leitend, und es gelangt elektrische Ladung von dem auf das $U_{DD}$-Potential geladenen Eingang der Ausgangsverstärkerschaltung Ai über den Längstransistor Tns auf die Matrixausgangsleitung zi. Für das Verhältnis des Spannungshubs $u_{Ai}$ am Eingang der Ausgangsverstärkerschaltung Ai zum Spannungshub $u_{zi}$ auf der Matrixausgangsleitung zi gilt dabei die Beziehung

$$\frac{u_{Ai}}{u_{zi}} = \frac{C_{zi}}{C_{Ai}},$$

worin $C_{zi}$ die Kapazität der Matrixausgangsleitung zi und $C_{Ai}$ die am Eingang der Ausgangsverstärkerschaltung Ai wirksame Schaltungskapazität bedeutet. Da nun die Kapazität $C_{zi}$ der langen Matrixausgangsleitung (Zeilenleitung) zi sehr viel größer ist als die Kapazität $C_{Ai}$ am Eingang der Ausgangsverstärkerschaltung Ai, führt dies am Eingang des Ausgangsverstärkers Ai zu einer entsprechenden Spannungsverstärkung, so daß bereits ein kleiner Signalhub auf der Matrixausgangsleitung zi genügt, um ein sicheres Erkennen des jeweils durchgeschalteten Bits am Ausgangsverstärker Ai zu gewährleisten. Dieses Bit kann dann am Ende der Bewertungsphase (ph in FIG 3) von der Ausgangsverstärkerschaltung Ai abgetaktet werden.

**Patentansprüche**

1.  Breitbandsignal-Koppeleinrichtung mit einer Koppelpunkt-Matrix in FET-Technik,
    deren Eingänge (ej-sj) jeweils mit einer Eingangstreiberschaltung (Ej) versehen sein können,
    deren Ausgänge (zi-ai) jeweils mit einer Ausgangsverstärkerschaltung (Ai) versehen sind und
    deren jeweils von einer Halte-Speicherzelle (Hij) gesteuerten Koppelelemente (Kij) jeweils mit einer **Serienschaltung** eines an seiner Steuerelektrode mit einem Durchschalte- bzw. Sperrsignal beaufschlagten Schalter-Transistors (Tnk) und eines mit seiner Steuerelektrode an die zugehörige Matrixeingangsleitung (sj) angeschlossenen Eingangs-Transistors (Tne) gebildet sind, **die** mit der der Serienschaltung abgewandten Hauptelektrode des einen Transistors (Tnk oder Tne) an die zugehörige Matrixausgangsleitung (zi) angeschlossen ist, welche ihrerseits über einen Vorladetransistor (Tpi), der mit seinem Steuereingang an die Taktsignalleitung (T) eines eine Bit-Durchschaltezeitspanne in eine Vorladephase (pv) und eine Bewertungsphase (ph) unterteilenden Koppelfeldansteuertaktes angeschlossen ist, mit einer Vorladepotentialquelle ($U_{DD}$) verbunden ist, wobei in jeder Vorladephase (pv) der Eingangstransistor (Tne) gesperrt und die Matrixausgangsleitung (zi) vorgeladen wird,
    **dadurch gekennzeichnet,**
    daß jeweils zwischen die Matrixausgangsleitung (zi) und die Ausgangsverstärkerschaltung (Ai) ein zusammen mit dem am Eingang der Ausgangsverstärkerschaltung (Ai) liegenden Vorladetransistor (Tpi) eine Ladungstransferschaltung bildender, mit seiner Steuerelektrode an einer Referenzpotentialquelle ($U_{ref}$) liegender n-Kanal-Längstransistor (Tns) eingefügt ist.

2.  Breitbandsignal-Koppeleinrichtung nach Anspruch 1,
    **dadurch gekennzeichnet,**
    daß die Referenzpotentialquelle ($U_{ref}$) durch einen Kondensator ($C_{Block}$) gegen Masse abgeblockt ist.

3.  Breitbandsignal-Koppeleinrichtung nach Anspruch 1 oder 2,
    **dadurch gekennzeichnet,**
    daß auch ein Vorladetransistor (Tpj), der am Eingang einer einer Matrixeingangsleitung (sj) vorgeschalteten Eingangstreiberschaltung (Ej) vorgesehen ist, mit seiner Steuerelektrode an die Vorladephase-Bewertungsphase-Taktsignalleitung (T) angeschlossen ist, von der her zugleich auch ein der Eingangstreiberschaltung (Ej) vorgeschaltetes Transfer-Gate (TGj) gesteuert wird.

## Claims

1. Broadband signal switching network having a crosspoint matrix in FET technology,
   the inputs (ej-sj) of which can each be provided with an input driver circuit (Ej),
   the outputs (zi-ai) of which are each provided with an output amplifier circuit (Ai), and
   the switching elements (Kij) of which, controlled by a holding memory cell (Hij) in each case, are each formed by a series circuit of a switching transistor (Tnk) whose control electrode receives a through-connect signal or inhibit signal and an input transistor (Tne) that is connected by its control electrode to the associated matrix input line (sj), which series circuit is connected to the associated matrix output line (zi) by the main electrode of the one transistor (Tnk or Tne) remote from the series circuit, which matrix output line is in turn connected to a precharging potential source ($U_{DD}$) via a precharging transistor (Tpi), which is connected by its control input to the clock signal line (T) of a switching network drive clock that subdivides a bit through-connection period into a precharging phase (pv) and an evaluation phase (ph), the input transistor (Tne) being inhibited and the matrix output line (zi) being precharged in every precharging phase (pv),
   characterized in that an n-channel series pass transistor (Tns), which is connected by its control electrode to a reference potential source ($U_{ref}$) and forms a charge transfer circuit together with the precharging transistor (Tpi) situated at the input of the output amplifier circuit (Ai), is inserted in each case between the matrix output line (zi) and the output amplifier circuit (Ai).

2. Broadband signal switching network according to Claim 1, characterized in that the reference potential source ($U_{ref}$) is blocked from ground by a capacitor ($C_{Block}$).

3. Broadband signal switching network according to Claim 1 or 2, characterized in that a precharging transistor (Tpj), which is provided at the input of an input driver circuit (Ej) connected upstream of a matrix input line (sj), is also connected by its control electrode to the precharging phase/evaluation phase clock signal line (T), by which a transfer gate (TGj) connected upstream of the input driver circuit (Ej) is also controlled at the same time.

## Revendications

1. Réseau de connexion pour signaux large bande comportant une matrice de points de connexion en technique FET,
   dont les entrées (ej-sj) peuvent chacune être munie d'un circuit (Ej) d'attaque d'entrée,
   dont les sorties (zi-ai) sont munies chacune d'un circuit amplificateur de sortie et
   dont les organes (Kij) de commutation commandés par une cellule (Hij) de mémoire de maintien sont formés d'un circuit-série constitué d'un transistor (Tnk) interrupteur recevant à son électrode de commande un signal de passage ou de blocage et d'un transistor (Tne) d'entrée connecté par son électrode de commande au conducteur (sj) d'entrée de matrice associé, lequel circuit-série est connecté par l'électrode principale, éloignée du circuit-série, de l'un des transistors (Tnk ou Tne) au conducteur (zi) de sortie de matrice associé, qui est relié pour sa part à une source (UDD) de potentiel de précharge par l'intermédiaire d'un transistor (Tpi) de précharge, qui est connecté par son entrée de commande au conducteur (T) de signal de cadence d'une cadence de commande de réseau de connexion divisant un intervalle de temps de transmission d'un bit en une phase (pv) de précharge et en une phase (ph) d'évaluation, le transistor (Tne) d'entrée étant bloqué pendant chaque phase (pv) de précharge et le conducteur (zi) de sortie de matrice étant préchargé pendant chaque phase (pv) de précharge,
   caractérisé en ce que
   il est inséré respectivement entre le conducteur (zi) de sortie de matrice et le circuit (Ai) amplificateur de sortie un transistor (Tns) longitudinal à canal n, qui forme avec le transistor (Tpi) de précharge se trouvant à l'entrée du circuit (Ai) amplificateur de sortie un circuit de transfert de charge et qui est connecté par son électrode de commande à une source ($U_{ref}$) de potentiel de référence.

2. Réseau de connexion pour signaux large bande suivant la revendication 1,
   caractérisé en ce que

la source (Uref) de potentiel de référence est mise à la masse par un condensateur ($C_{Block}$).

3. Réseau de connexion pour signaux large bande suivant la revendication 1 ou 2,
   caractérisé en ce que
   également un transistor (Tpj) de précharge, qui est prévu à l'entrée d'un circuit (Ej) d'attaque d'entrée branché en amont d'un conducteur (sj) d'entrée de matrice, est connecté par son électrode de commande au conducteur (T) du signal de cadence à phase de précharge et à phase d'évaluation, à partir duquel est commandée également en même temps une porte (TGj) de transfert branchée en amont du circuit (Ej) d'attaque d'entrée.

# FIG 1

FIG 2

FIG 3